# EUROPEAN PATENT SPECIFICATION

(11) **EP 1 684 345 B1**
(45) Date of publication and mention of the grant of the patent: **25.09.2013**
(21) Application number: 06000841.4
(22) Date of filing: 16.01.2006
(51) Int. Cl.: H01L 23/495

(54) **Surface mount semiconductor device**
Oberflächenmontiertes Halbleiterbauteil
Composant semi-conducteur monté en surface

(30) Priority: 21.01.2005 JP 2005014204
(43) Date of publication of application: 26.07.2006
(73) Proprietor: STANLEY ELECTRIC CO., LTD., Tokyo 153-8636 (JP)
(72) Inventor: Kamikawa, Toshimi, Tokyo 153-8636 (JP); Oba, Hayato, Tokyo 153-8636 (JP); Miyamura, Shinichi, Tokyo 153-8636 (JP)
(74) Representative: Wagner & Geyer

(56) References cited:
- EP-A2- 1 267 423
- DE-C1- 10 102 119
- JP-A- 2 014 555
- JP-A- 7 088 564
- JP-A- 8 008 375
- JP-A- 58 215 061
- JP-A- 60 254 646
- JP-A- 2000 294 711
- US-A1- 2002 185 650

## Description

### BACKGROUND OF THE INVENTION

### 1. Field of the Invention

The present invention relates to a surface mount semiconductor device. More particularly, the present invention relates to a surface mount semiconductor device using a package formed by insert-molding a lead frame with a resin.

### 2. Description of the Related Art

Various structures for a surface mount semiconductor device are known. For example, Japanese Patent Laid-Open Publication No. JP 2003-007946 A describes the following structure as a conventional technique. A lead frame for multiple devices is manufactured by pressing and stamping a metal board. The lead frame is then insert-molded with a resin so as to form a plurality of packages for surface mount semiconductor devices. Each package has a concave portion at its center. Then, a semiconductor chip is mounted on the lead frame exposed at a bottom of the concave portion of each package and is sealed with a resin. Finally, the lead frame projecting laterally from a side face of each package is bent (i.e., a forming process) so as to extend around the package toward a rear surface of the package via the side face.

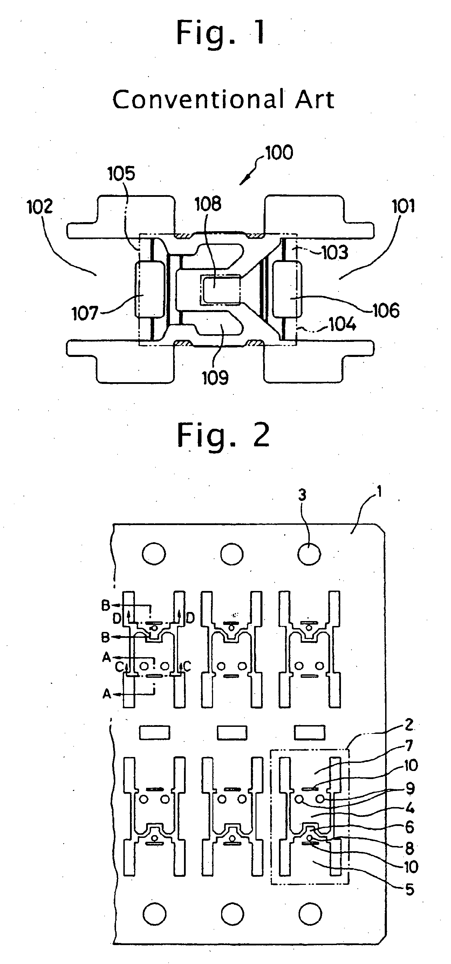

Fig. 1 partially shows a part of the lead frame for multiple devices, which is used in the aforementioned surface mount semiconductor device. The shown part corresponds to one surface mount semiconductor device. The lead frame 100 includes a lead portion 101 on which a semiconductor chip is to be mounted (die-bonded) and a lead portion 102 to which one end of a bonding wire connected to the semiconductor chip at the other end thereof is connected (wire-bonded). Those two lead portions 101 and 102 are separated from each other.

A package 103 is formed by insert molding with a resin on a die bonding pad 108 and a wire bonding pad 109 that are parts of the lead frame 100 at which die bonding and wire bonding are achieved, respectively. The lead portions 101 and 102 projecting laterally from a pair of opposed side faces 104 and 105 of the package 103 are bent along the side faces 104 and 105 and a rear face (not shown) of the package 103.

Elongate through holes 106 and 107 are provided at centers of the lead portions 101 and 102, respectively. Each of the elongate through holes 106 and 107 has an approximately rectangular shape that is approximately perpendicular to a projecting direction of the corresponding lead portion 101 or 102 from the side face of the package 103 when the package 103 is formed. The lead portions 101 and 102 projecting from the package 103 can be bent approximately perpendicularly along the side faces 104 and 105 of the package 103 at positions of the elongate through holes 106 and 107, respectively. The reason for providing the elongate through holes 106 and 107 is that the elongate through holes 106 and 107 can reduce cross-sectional areas of bending portions of the lead portions 101 and 102, respectively, thereby enabling the forming process to be easily performed with a smaller load, as compared with a case in which the elongate through holes 106 and 107 are not provided.

Accordingly, it is possible to suppress stress that is applied to the package 103 near positions from which the lead portions 101 and 102 project in the forming process performed for the lead portions 101 and 102, when the package 103 is formed. It is also possible to prevent occurrence of troubles such as degradation of adhesiveness between the package 103 and the lead portions 101 and 102 and breakage of the package 103, caused by a heat generated in soldering in a mounting process, a heat generated from the semiconductor chip that is operating, or the like. Therefore, it is possible to prevent the electric property from becoming poor because of poor moisture resistance caused by the above troubles.

As the length of the elongate through holes 106 and 107 that are provided at the positions at which the lead portions 101 and 102 project from the package 103 and are bent becomes closer to the width of the lead portions 101 and 102, the cross-sectional areas of the bending portions of the lead portions 101 and 102 are reduced. Therefore, the lead portions 101 and 102 can be easily bent with a smaller load.

However, the above reduction of the cross-sectional area makes a thermal resistance of each lead portion 101 or 102 larger. Therefore, a property for radiating the heat generated from the semiconductor chip is degraded, thus degrading the properties of the semiconductor chip. Moreover, the lead portions 101 and 102 may be broken by vibration or impact after mounting. In this case, the semiconductor device is inoperative. In addition, the elongate through holes 106 and 107 are partially located in the package 103. Thus, when the elongate through holes 106 and 107 become larger, moisture absorption into the package 103 may proceed more so as to make the properties of the semiconductor chip poor.

Japanese Patent Application Laid-Open No. Sho 58-215061 (JP 58-215061 A1) discloses a semiconductor device and a method for manufacturing the same. In order to improve the strength by a method wherein a deformable part such as a thin part is provided at the bending part of external leads projected out from a package, they are bent without cracks or clearances to the main body, and reinforcing material is adhered after deformation. When a lead frame is formed, a hole is formed at the center of the lead width of the bending part of the external lead. When the external lead is pressed down by fixing the package main body and putting a roller onto the top end side of the external lead, it is easily bent at the deformable part. Next, it is dipped in the bath of solder, thus the surface of the lead is coated with solder, and the hole is filled with solder, resulting in formation as a part of the lead. In addition to the hole, it is effective also to provide a groove or a cutout at the thin part or in the width direction. This constitution produces no cracks of the package main body and no clearances between the leads, and a device of high reliability can be obtained without breaks of leads after bending. The semiconductor device includes a package main body and external leads projected from the package main body, the external leads being bent by forming an easy-to-bend portion with a reduced thickness by hole, notch, groove, etc. This portion is provided in order to be easily bent therealong. Accordingly, the function is the same as the previous prior art.

US 2002/185650 A1 discloses provides a photocoupler capable of reducing the mount area required to mount the photocoupler on an object by eliminating a structurally unnecessary portion, and an apparatus and method for fabricating such a photocoupler. A light-receiving device and a light-emitting device placed on a pair of lead frames are embedded in a primary mold body made of a transparent resin, and the primary mold body is embedded in a secondary mold body made of a light-shading resin, to form the photocoupler. The lead frames are bent inside the secondary mold body, and the outer side of the terminal portion of each lead frame, ranging from the bent position to the top end, is exposed at the secondary mold body.

EP 1 267 423 A2 was used as a basis for the preamble of claim 1 and discloses a light-emitting device in which a lead frame is used and which has leads projecting from a package to be opposed to each other while being bent along the side faces of the package at portions at which the leads project from the package.

JP 02-014555 A discloses a resin-sealed type semiconductor device. More particularly, a plurality of fine grooves each having an overhung cross section are formed in a direction perpendicular to the bending direction of the lead frame on an inner surface and an outer surface of the lead frame at positions where the lead frame is in contact with a resin layer. Solder was inserted or adhered to the insides of the groove or its surrounding outside the above-described resin-sealed semiconductor device, and the lead frame was bent. Accordingly, after adhesion of the solder, there is no thinned portion in the thickness direction at the bent portion of the lead frame. Furthermore, the provided grooves extend entirely over the lead frame width. Accordingly, this technique is different from the present invention.

### SUMMARY OF THE INVENTION

The present invention was made in view of the aforementioned problems. It is an object of the present invention to provide a surface mount semiconductor device using a lead frame, in which, assuming that a lead portion projecting from a package formed by insert-molding the lead frame with a resin is bent approximately perpendicularly along a side face of the package, the cross-sectional area of the lead at a center of a bending portion of the lead is reduced in advance, and which can prevent disconnection and ensure moisture resistance without impairing a heat radiation property.

According to the present invention, there is provided a surface mount semiconductor device as set forth in claim 1. Preferred embodiments of the present invention may be gathered from the dependent claims.

Thus, the present invention has the following advantages; It is possible to suppress stress applied to the package near the bending portions of the respective leads when the leads are bent; It is also possible to prevent occurrence of troubles such as degradation of adhesiveness between the package and the leads and breakage of the package, caused by a heat generated in soldering in a mounting process, a heat generated from an operating semiconductor chip, or the like. Therefore, it is possible to prevent electric properties from becoming poor because of poor moisture resistance caused by the above troubles.

### BRIEF DESCRIPTION OF THE DRAWINGS

These and other objects and advantages of the invention will become clear from the following description with reference to the accompanying drawings, wherein:
Fig. 1 is a plan view of a lead frame used in a conventional surface mount semiconductor device;
Fig. 2 is a plan view of a lead frame used in an exemplary embodiment of a surface mount semiconductor device according to the present invention;
Fig. 3 is a cross-section view taken along the line A-A and the line B-B in Fig. 2;
Fig. 4 is a cross-section view taken along the line A-A and the line B-B in Fig. 2;
Fig. 5 is a cross-section view taken along the line C-C and the line D-D in Fig. 2;
Fig. 6 is a cross-section view taken along the line C-C and the line D-D in Fig. 2;
Fig. 7 is a plan view of the lead frame used in the exemplary embodiment of the surface mount device according to the present invention, after the lead frame is insert-molded with a resin;
Fig. 8 is a cross-sectional view taken along the line E-E in Fig. 7.
Fig. 9 is a perspective view showing an exemplary embodiment of the surface mount device according to the present invention.

### DETAILED DESCRIPTION OF PREFERRED EMBODIMENT

A preferred exemplary embodiment of the present invention will now be described in detail, with reference to Figs. 2 to 9 (the same components are labeled with the same reference numerals). The exemplary embodiment described below has various limitations that are technically preferable, because that exemplary embodiment is a preferable specific example of the present invention. However, the scope of the present invention is not limited by that exemplary embodiment, unless the description for limiting the present invention is made.

Fig. 2 shows a lead frame 1 for multiple devices, which is used for a surface mount semiconductor device according to the present exemplary embodiment. For example, the lead frame 1 can be formed by pressing and stamping or etching a metal plate to remove an unnecessary portion of the metal plate. Here, the metal plate can be formed by a Cu alloy plate plated with Ni, Pd, Au, Ag, or the like.

A plurality of the same lead patterns 2 that are independent of each other can be arranged in one line at predetermined intervals in the lead frame 1 for multiple devices. Each of the lead patterns 2 can form an individual surface mount semiconductor device. Alternatively, there may be two lines of the lead patterns 2 in the lead frame 1. A plurality of feed holes 3 can be provided at both ends of the lead frame 1 along a longitudinal direction of the lead frame 1 so as to be arranged at predetermined intervals on straight lines parallel to each other.

The lead pattern 2 can include a pair of leads that are separated from each other. One lead 5 can have a die bonding pad 4 to which a semiconductor chip is die-bonded. The other lead 7 can have a wire bonding pad 6 to which one end of a bonding wire connected to an upper electrode of the die-bonded semiconductor chip at the other end is connected.

One through hole 8 may be provided in the lead 5 and two through holes 9 may be provided in the lead 7. Parts of a package that is formed by insert-molding the lead frame 1 with a resin so as to cover the leads 5 and 7 from both sides are connected to each other via the through holes 8 and 9 in the leads 5 and 7, so that the leads 5 and 7 and the package covering those leads 5 and 7 from both sides are fixed and integrated as one unit.

Moreover, a concave portion 10 is provided in each of the leads 5 and 7. The concave portion 10 is arranged outside the through hole 8 or the through holes 9 at the center of each lead 5 or 7. The position of the concave portion 10 corresponds to a base of the package formed by insert molding with a resin. The concave portions 10 correspond to bending portions at which the leads 5 and 7 projecting laterally from side faces of the package are bent approximately perpendicularly along the side faces of the package in a forming process. The concave portions 10 are provided in order to reduce cross-sectional areas of the bending portions of the leads 5 and 7, thereby enabling the leads 5 and 7 to be easily bent with a smaller load.

The concave portion 10 formed in each of the leads 5 and 7 can have various structures. Basically, the concave portions 10 are formed to extend parallel to the side faces of the package from which the leads 5 and 7 project in such a manner that the concave portions 10 do not penetrate through the leads 5 and 7, respectively. Moreover, no concave portion is formed on at least a part of a straight line on which the concave portion 10 is provided, so that the thickness of the lead 5 or 7 can be maintained at that part without change.

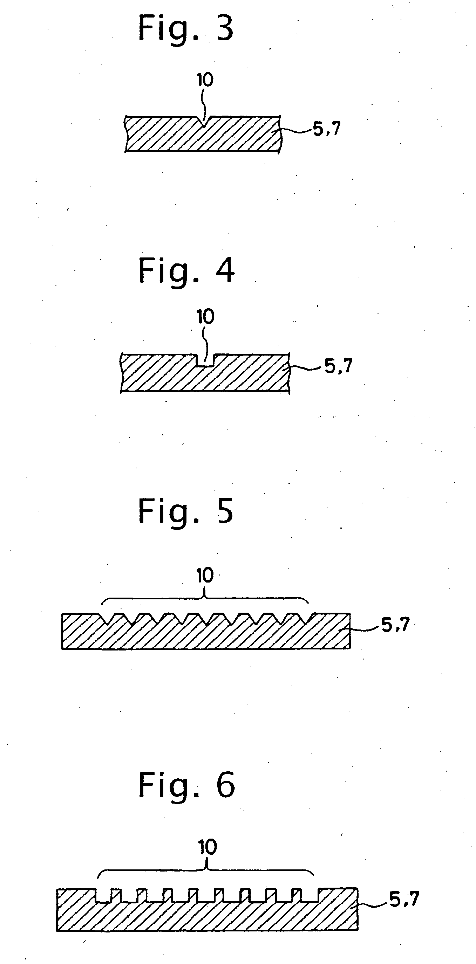

The exemplary shapes of the concave portion 10 are shown in Figs. 3 to 6. Fig. 3 shows a cross section taken along the line A-A and the line B-B in Fig. 2 and shows a first exemplary shape of the concave portion 10. Fig. 4 also shows a cross section taken along the line A-A and line B-B in Fig. 2 and shows a second exemplary shape of the concave portion 10. Fig. 5 shows a cross section taken along the line C-C and the line D-D in Fig. 2 and shows a third exemplary shape of the concave portion 10. Fig. 5 also shows a cross section taken along the line C-C and the line D-D in Fig. 2 and shows a fourth exemplary shape of the concave portion.

The first exemplary shape of the concave portion 10 is formed by an elongate groove having an approximately V-shaped cross section when the concave portion 10 is cut along the direction in which the lead extends. The second exemplary shape of the concave portion 10 is formed by an elongate groove having an approximately U-shaped cross section when the concave portion 10 is cut along the direction in which the lead extends. The third exemplary shape of the concave portion 10 is formed by a plurality of approximately V-shaped independent grooves that are arranged on an approximately straight line, when the concave portion 10 is cut along the direction perpendicular to the direction in which the lead extends (the widthwise direction of the lead). The fourth exemplary shape of the concave portion 10 is formed by a plurality of approximately U-shaped independent grooves that are arranged on an approximately straight line, when the concave portion 10 is cut along the direction perpendicular to the direction in which the lead extends.

It is desirable that a depth of the groove having the approximately V-shaped cross section and that of the groove having the approximately U-shaped cross section be within a range from 1/5 to 2/3 of the thickness of the lead frame.

In any of the above four exemplary shapes of the concave portion, the cross-sectional area of the lead at the concave portion is smaller than that at any other portions of the lead where no concave portion is provided. Therefore, when the lead is bent at the concave portion, it is possible to easily bend the lead with a smaller load.

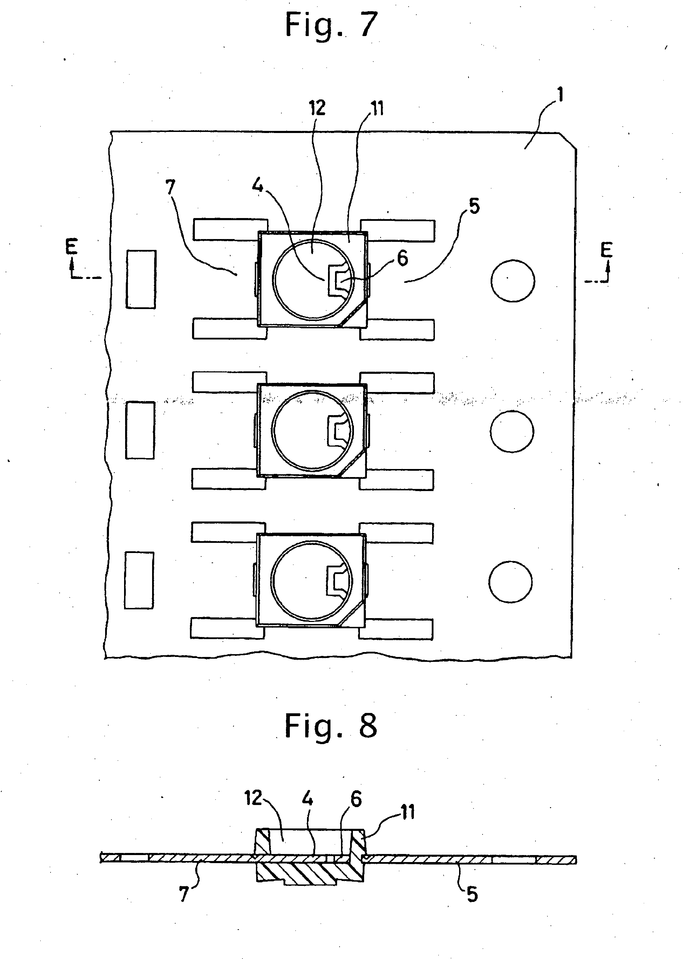

Figs. 7 and 8 show a state in which a package 11 is formed by insert-molding the aforementioned lead frame 1 with a resin. Fig. 7 is a plan view and Fig. 8 shows a cross section taken along the line E-E in Fig. 7. A concave portion 12 is formed at a center of the package 11. The die bonding pad 4 and the wire bonding pad 6 of the leads 5 and 7 are exposed at a bottom of the concave portion 12. The lead portions 5 and 7 laterally project from side faces of the package 11, respectively.

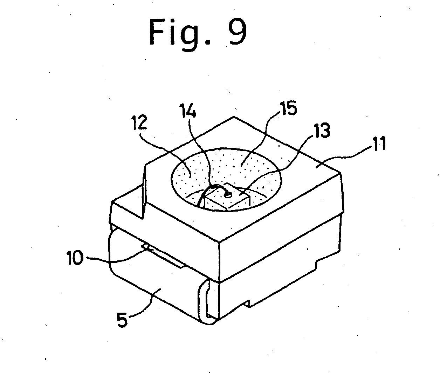

Fig. 9 shows a surface mount semiconductor device having been completed in the following manner; The individual packages 11 are formed on the lead frame 1 for multiple devices; The die bonding pad and the wire bonding pad are exposed at the bottom of the concave portion 12 of each package 11 and a semiconductor chip 13 is die-bonded to each die bonding pad and a bonding wire 14 is wire-bonded to each wire bonding pad; Then, the concave portion 12 is filled with a transparent resin 15 to seal the semiconductor chip 13 and the bonding wire 14 with the transparent resin 15; The lead portions 5 and 7 projecting from the side faces of the package 11 are bent approximately perpendicularly along the side faces of the package 11 at the positions at which the leads 5 and 7 project from the package, and are further bent approximately perpendicularly along the bottom of the package. Finally, the individual semiconductor devices are separated from each other.

As is apparent from Fig. 9, the cross-sectional area of each of the leads 5 and 7 projecting laterally from the side faces of the package 11 can be reduced by providing the concave portions 10 at the positions at which the leads project from the package 11 and are bent approximately perpendicularly along the side face of the package 11 so as not to penetrate through the leads 5 and 7 in a thickness direction, respectively. Thus, it is possible to easily bend the leads 5 and 7 with a smaller bending load.

As a result, stress applied to the package near the position from which the leads project when the leads are bent can be suppressed. It is also possible to prevent occurrence of troubles such as degradation of adhesion between the package and the leads and breakage of the package, caused by a heat generated in soldering in the mounting process, a heat generated from the semiconductor chip that is operating, or the like. Therefore, it is possible to prevent electric properties from becoming poor because of poor moisture resistance caused by the above troubles.

Moreover, instead of providing the concave portion across the full width of each lead, according to the present invention the concave portion is preferably provided at the center of each lead while the thickness of that lead is maintained at a portion other than the concave portion. Thus, even if external stress such as vibration or impact is applied to the surface mount semiconductor device of the present invention after the surface mount semiconductor device is mounted, disconnection can be prevented because of protection by the thicker portion of the lead, and a function of the device can be maintained.

Reduction of the cross-sectional area of the lead makes a thermal resistance larger and therefore degrades a property for radiating a heat generated from a semiconductor chip. This degrades the properties of the semiconductor chip. However, a reduction rate of the cross-sectional area is smaller and the thermal resistance is relatively smaller, as compared with a conventional method for providing an elongate through hole. Thus, the degree of degradation of the properties of the semiconductor chip caused by degradation of the heat radiation property is low and is less of an obstacle in use.

## Claims

1. A surface mount semiconductor device comprising:
a lead frame (1);
a package that is formed of a resin and has a concave portion (12), the lead frame (1) as an insert being insert-molded to the package;
a semiconductor element (13) mounted at a bottom of the concave portion (12) and electrically connected with the lead frame (1); and
a resin sealing portion which seals the semiconductor element (13) with a transparent resin, in which the concave portion (12) is filled with the transparent resin;
wherein the lead frame (1) has a pair of leads (5, 7) projecting laterally from side faces of the package that are opposed to each other, and the leads (5, 7) being bent perpendicularly along the side faces of the package at bend portions at which the leads (5, 7) project from the package;
the surface mount semiconductor device being **characterized in that**:
each lead (5, 7) has a concave elongate groove (10) provided at the center thereof and on the outer surface of the bend portion in a direction perpendicular to the direction in which the lead extends and which is shorter than the width of the lead;
each concave elongate groove comprising a plurality of concave short grooves (10) which are provided parallel to the direction in which the lead extends to reduce the cross section of the lead and which do not penetrate through that lead (5, 7) in a thickness direction,
while the thickness of that lead is maintained at a portion other than the concave elongate groove.

2. The surface mount semiconductor device according to claim 1, wherein a cross-sectional shape of the grooves is V-shaped or U-shaped when the bending portion of the lead (5, 7) is cut parallel to the side face of the package from which that lead (5, 7) projects.

3. The surface mount semiconductor device according to any one of preceding claims, wherein a depth of the grooves is within a range from 1/5 to 2/3 of the thickness of the lead.

## Patentansprüche

1. Ein oberflächenmontiertes Halbleiterbauelement, das Folgendes aufweist:
einen Leiterrahmen (1);
ein Paket, das aus einem Gießharz gebildet ist und einen konkaven Teil (12) aufweist, wobei der Leiterrahmen (1) als Einsatz in dem Paket umspritzt ist;
ein Halbleiterelement (13), das an einem Boden des konkaven Teils (12) montiert ist und elektrisch mit dem Leiterrahmen (1) verbunden ist; und
ein Gießharzabdichtteil, das das Halbleiterelement (13) mit einem transparenten Gießharz abdichtet, wobei der konkave Teil (12) mit dem transparenten Gießharz gefüllt ist;
wobei der Leiterrahmen (1) ein Paar von Anschlüssen (5, 7) aufweist, die seitlich von gegenüberliegenden Seitenflächen des Pakets herausragen, wobei die Anschlüsse (5, 7) senkrecht entlang der Seitenflächen des Pakets an Biegungsteilen abgebogen sind, an denen die Anschlüsse (5, 7) von dem Paket herausragen; wobei das oberflächenmontierte Halbleiterbauelement **dadurch gekennzeichnet ist, dass**:
jeder Anschluss (5, 7) eine konkave, längliche Nut (10) aufweist, die in der Mitte desselben und auf den Außenflächen des Biegungsteils in einer Richtung senkrecht zu der Richtung in die sich der Anschluss erstreckt angeordnet ist, und die kürzer ist als die Breite des Anschlusses;
wobei jede konkave, längliche Nut eine Vielzahl von konkaven, kurzen Nuten aufweist, die parallel zu der Richtung in die sich der Anschluss erstreckt angeordnet ist, um den Querschnitt des Anschlusses zu reduzieren, und wobei die konkaven, kurzen Nuten nicht in Richtung der Dicke des Anschlusses durch den Anschluss (5, 7) dringen, während die Dicke des Anschlusses in einem Teil, unterschiedlich zu der konkaven, länglichen Nut, beibehalten wird.

2. Das oberflächenmontierte Halbleiterbauelement nach Anspruch 1, wobei eine Querschnittsform der Nuten V-förmig oder U-förmig ist, wenn der Biegungsteil der Anschlüsse (5, 7) parallel zu der Seitenfläche des Pakets geschnitten ist, von der der Anschluss (5, 7) herausragt.

3. Das oberflächenmontierte Halbleiterbauelement nach einem der vorhergehenden Ansprüche, wobei eine Tiefe der Nuten in einem Bereich von 1/5 bis 2/3 der Dicke des Anschlusses liegt.

## Revendications

1. Dispositif semiconducteur monté en surface compre-nant :
une grille de connexion (1) ;
un boîtier qui est formé en résine et qui comporte une portion concave (12), la grille de connexion (1) étant insérée par moulage sous forme d'un insert dans le boîtier ;
un élément semiconducteur (13) monté au fond de la portion concave (12) et connecté électriquement à la grille de connexion (1) ; et
une portion d'étanchéité en résine qui étanchéifie l'élément semiconducteur (13) avec une résine transparente, la portion concave (12) étant remplie avec la résine transparente ;
dans lequel la grille de connexion (1) comporte une paire de conducteurs (5, 7) faisant saillie latéralement à partir de faces latérales du boîtier qui sont opposées entre elles, et les conducteurs (5, 7) sont courbés perpendiculairement le long des faces latérales du boîtier au niveau de portions courbées au niveau desquelles les conducteurs (5, 7) font saillie hors du boîtier ;
le dispositif semiconducteur monté en surface étant **caractérisé en ce que** :
chaque conducteur (5, 7) comporte une gorge allongée concave (10) prévue en son centre et sur la surface extérieure de la portion courbée dans une direction perpendiculaire à la direction dans laquelle s'étend le conducteur et qui est plus courte que la largeur du conducteur ;
chaque gorge allongée concave comprenant une pluralité de gorges courtes concaves (10) qui sont prévues parallèles à la direction dans laquelle s'étend le conducteur pour réduire la section du conducteur et qui ne pénètrent pas dans ce conducteur (5, 7) dans la direction de l'épaisseur, alors que l'épaisseur de ce conducteur est maintenue au niveau d'une portion autre que la gorge allongée concave.

2. Dispositif semiconducteur monté en surface selon la revendication 1, dans lequel la section des gorges est en forme de V ou de U lorsque la portion de courbure du conducteur (5, 7) est coupée parallèle à la face latérale du boîtier à partir de laquelle ce conducteur (5, 7) fait saillie.

3. Dispositif semiconducteur monté en surface selon l'une quelconque des revendications précédentes, dans lequel la profondeur des gorges est comprise entre 1/5 et 2/3 de l'épaisseur du conducteur.
